**Europäisches Patentamt**

**European Patent Office**

**Office européen des brevets**

(19)

(11) Publication number: **0 014 043**
A1

# (12) EUROPEAN PATENT APPLICATION

(21) Application number: **80300070.2**

(22) Date of filing: **08.01.80**

(51) Int. Cl.³: **H 01 L 41/22, H 01 G 7/02**

(30) Priority: **30.01.79 GB 7903224**
**03.04.79 GB 7911672**

(43) Date of publication of application: **06.08.80**
**Bulletin 80/16**

(84) Designated Contracting States: **BE CH DE FR IT NL**

(71) Applicant: **International Standard Electric Corporation, 320 Park Avenue, New York 22, N. Y. (US)**

(72) Inventor: **Tester, Norman William, 25 Sakins Croft, Harlow, Essex (GB)**

(74) Representative: **Capsey, Sydney Ross et al, ITT UK Patent Department Maidstone Road, Foots Cray Sidcup DA14 5HT (GB)**

(54) **Piezo-electric film manufacture and transducer.**

(57) A process for making piezo-electric polyvinylidene fluoride (PVDF) film for use, for example, as diaphragms for telephone transmitters, includes the steps of

(a) stretching the melt-extruded film (1) parallel to the extrusion direction with a stretch ratio of about 4 to 1 at about 120°C to convert it to a β crystalline form,

(b) clamping the film between conductive rubber pads (5, 6) to which the polarizing voltage, e.g. 1.3 kv for 12 μm film is applied. While the voltage is thus applied the film is heated to about 110°C for 130 mins. and cooled to ambient with the polarizing field preset,

(c) conductive elastomer electrodes are applied to the film in the desired pattern, and

(d) the piezo-electric properties are stabilized by heating the foil to about 90°C for 2 hours.

Such a film, or an electret film is usable as the diaphragm of an electro-acoustic or electro-mechanical transducer in which case the conductive elastomer used for the electrodes is an insulating material loaded with particles of an electrically conductive material such as carbon. This gives an electrode which is cheap, easy to apply, and provides a good contact.

## PIEZO-ELECTRIC FILM MANUFACTURE
## AND TRANSDUCER

This invention relates to the manufacture of piezo-electrically active plastics film, commencing with the film material in the "raw" state, and to electro-acoustic or electro-mechanical transducer using such diaphragms.

One material which has been used as the active element of an acoustic-electric transducer is polyvinylidene fluoride (PVDF), and the use of such active film materials in such a transducer will be described herein.

In making the diaphragm for such applications it is necessary to apply electrodes to the two faces of the film material. This is usually performed by vacuum evaporation, which needs expensive equipment. Further, as the film has to be continuously polarized the film is usually electroded over a large proportion of its surface area. However, when the material is to be used, e.g. in a transducer, it is often required that only isolated regions have to be electroded. Hence the metallization has to be partly removed to give the required electrode shape, or the entire electrode must be removed and a new electrode of the required size applied.

Conventional processes for making such films for use in such transducers are described in British Patent Nos. 1108234 and 1367738, and have difficulties when continuous production is called for.

This invention seeks to overcome the above-mentioned disadvantages.

According to the present invention there is provided a process for the production of piezo-electric film, in which melt-extruded film of the material to be rendered piezo-electric is stretched, which stretching is effected in a direction parallel to the extrusion direction with a stretch ratio and at a temperature such that the material of the film is converted into a form in which it can be rendered piezo-electric; characterized in this, that the film is clamped between layers of conductive rubber or rubber-like material to which is applied a polarizing voltage of a magnitude appropriate to the material to be rendered piezo-electric and to the thickness thereof, the film being held at that temperature for a time appropriate to the production of the desired piezo-electricity, whereafter the film is cooled to room temperature with the polarizing field still applied, that electrodes of an electrically-conductive elastomer are printed or otherwise formed onto the film in the required patterns, said electrodes being applied to one or both sides of the film, and that the piezo-electric properties of the film are stabilized by heating the film at a temperature intermediate the temperature used in step (b) and the highest temperature to which it is expected that the films will be subjected when in use, the order in which steps (c) and (d) are performed being reversed.

A diaphragm of this type for use in a transducer requires for its operation that one or both of its surfaces carry electrodes to which electrical contact can be made. Conventionally such electrodes consist of a thin metal film applied by vacuum coating or electroplating methods. The connections to the electrodes are usually pressure contacts, since a soldering or welding operation would damage the plastics foil. In addition, most metals that would be otherwise suitable for use as electrodes suffer from one or both of the following problems:

(a) the thin film may be damaged by corrosive atmospheres containing, for example, sulphur dioxide or salt,

(b) the metal surface may have an oxide layer which causes poor contact at the low current produced by the transducer with the light contact pressure which can be applied.

A further object of the present invention is to provide an electro-acoustic or electro-mechanical transducer in which the above problems are minimized or even overcome.

According to the invention there is provided an electro-acoustic or electro-mechanical transducer which includes a diaphragm of an electrically active plastics material having electrically conductive electrodes on one or both of its two faces, wherein each said electrode is of an elastomer material having particles of an electrically conductive material dispersed in it.

According to the invention there is also provided an electro-acoustic transducer, which includes a diaphragm of a plastics material which is an electret or is piezo-electric, said diaphragm having electrically conductive electrodes on one or both of its two faces, wherein each said electrode is of an elastomer material having carbon particles dispersed in it.

Such an arrangement provides an inexpensive simply-applied electrode which is free of corrosion and to which a simple, reliable, pressure contact can be made. Such an electrode in a preferred arrangement consists of a layer of an elastomer material containing carbon particles to make it conductive. These particles do not corrode, and the elastic matrix does not unduly increase the stiffness of the transducer element. As the layer is an elastomer, it will not crack during operation, nor when the diaphragm is made into a domed or cylindrical form, as required by some forms of piezo-electric transducer. This electrode can be applied as a step in the process mentioned above.

For the elastomer it is preferred to use synthetic materials, as these do not deteriorate over a period of time, as happens with a natural latex. Fluorine-containing polymers are especially suitable for this purpose as they are highly stable and are not damaged by high temperature during use, or during the polarization of the foil.

A process embodying the invention, and transducer arrangements using the invention will now be described with reference to the drawings, in which:

Fig. 1 is a schematic diagram explanatory of a process embodying the invention.

Fig. 2 is a cross-section of a first embodiment of the invention.

Fig. 3 is a second embodiment of the invention, also shown in cross-section.

Fig. 4 is a third embodiment of the invention, also shown in cross-section.

In the process to be described herein, the material used is polyvinylidene fluoride, known as PVDF. The PVDF film without metallization is clamped between two sheets of silicone rubber which have been made conductive by the addition of carbon particles, and the polarization voltage is applied between these sheets. After polarization, the permanent electrodes are applied over the required areas by screen printing, spraying or brushing, the material thus applied being a thin layer of elastomer-containing conductive particles. Silicone rubber containing metal particles may also be used for the electrodes, but with such material the maximum polarizing field which can be applied without breakdown of the PVDF film has been found to be lower than with a carbon-containing rubber.

After the stretching process (see below) the film shrinks when heated. To stabilize its dimensions the film is, in the prior art process, heat-treated at the polarizing temperature or higher while subjected to restraint to prevent any gross change in dimensions. Subsequent heating to a lower temperature during use does not then produce large dimensional changes. We have found that by clamping the film between the conductive sheets during polarization the film is prevented from shrinking, and the separate heat treatment hitherto used may be dispersed with.

In our process, melt-extruded PVDF sheet is stretched uni-axially along the extrusion direction by the natural stretch ratio while the temperature is maintained at less than $120^{\circ}C$. Under these conditions a large part of the mainly amorphous extruded sheet is converted to the $\beta$ crystalline form, which is suitable to be rendered piezo-electric. At the same time the thickness of the material is reduced to a value suitable for use as transducer diaphragms. A suitable stretching temperature has been found to be $100^{\circ}C$ with a stretch ratio of 4 to 1. The stretching is preferably performed continuously by winding the film between two rollers driven at different speeds, the take-up roller being the faster rotating one. The speed at which the film leaves the supply roll and the speed at which it is wound onto the take-up roll are monitored, and a control system is used to maintain the required stretch ratio by varying the speed of one of the two drive motors. The region over which the stretching takes place is heated to the required stretch temperature.

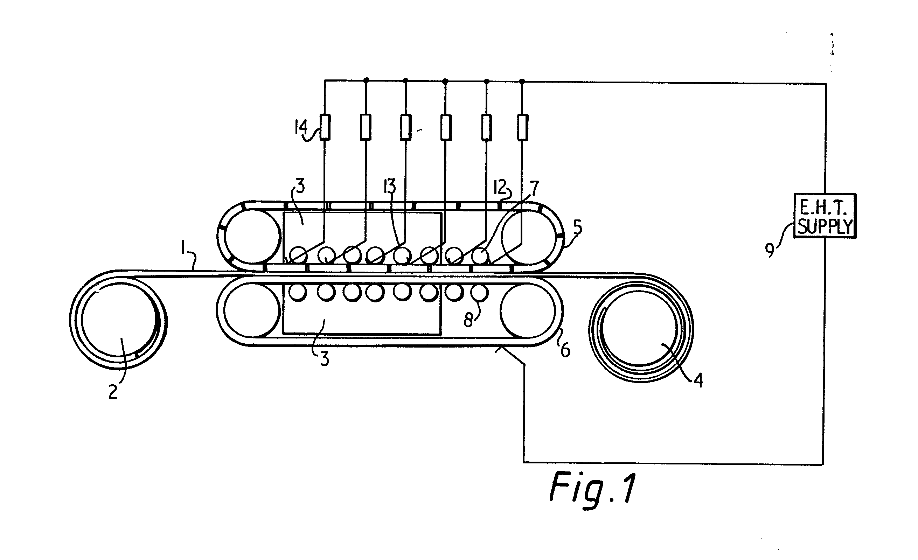

We now describe the continuous polarizing process, with reference to the accompanying Fig. 1.

The film 1 to be treated is passed from a supply reel 2 through a slot and into a chamber 3, which it leaves via another slot and is wound onto a take-up reel 4. The chamber 3 is heated to the polarization temperature, which is $110^{\circ}C$ in the present example. During its passage through the chamber 3, as well as before entering and after leaving the chamber 3, the film is clamped between two endless belts 5 and 6, which run over a series of rollers, such as 7, 8.

One of the belts 6 has on its surface a continuous layer of silicone rubber containing carbon particles to render it electrically conductive, and this layer is connected to one terminal of an EHT supply 9. The other belt 5 also has electrically conductive silicone rubber on its surface, but this is applied in electrically isolated regions with an insulative strip such as 12 or a gap a few millimetres wide between each such region. Note here that a gap between the edges of two adjacent silicone rubber regions is in effect an electrically insulative gap.

By a series of slidable contacts such as 13 on the edge, or on the inner surface of the belt, each region of conductive rubber is connected via a resistor such as 14 to the EHT supply 9. This arrangement of separate regions of conductive rubber effectively connected to the source 9 via resistors means that if a defect in the film being treated causes the belts to be short-circuited, only the region of the film covered by the section involved fails to be polarized.

Hence the whole length of film between the two belts is not wasted. By keeping the inter-region gaps as small as possible, only a little of the film is not completely polarized, and because of the fringing field at the edge of the sheet the loss of activity is small.

The polarization voltage used should be as large as possible, to obtain the maximum piezo-electric effect. The electric field is, however, limited by the dielectric strength of the film to about $10^8$ volts/metre at a polarizing temperature of $110^{\circ}$C. For a 12 $\mu$m film this means a polarizing voltage of about 1300 volts. The piezo-electric constants increase with polarization time up to a limiting value: in the case of the temperature and field strengths used in the present example, very little improvement in piezo-electric properties is achievable after a polarization time of about 30 mins. Hence the length of the polarization chamber 3 and the speed of travel of the film are such that the film remains in the polarizing field for at least 30 mins.

After it leaves the heated chamber 3 the film is cooled to $50^{\circ}$C or lower before the polarizing film is removed. This can be seen to be so in the drawing, because of the electrodes 13 which are shown to the right of the exit slot of the chamber 3. The rate of cooling is not important, but to reduce the lengths of the continuous belts needed if natural cooling is used the final clamping rollers may be water cooled. The film may now be wound onto the take-up reel 4, or may pass directly to the stabilization heating stage.

This next stage involves heating the film without constraints to stabilize its piezo-electric and mechanical properties. This final heating must be effected at a temperature below the polarization temperature but above any temperature which the material is expected to experience during its subsequent use.

Thus if the maximum temperature to which a transducer housing a diaphragm of this film is expected to be subjected is 70$^{\circ}$C, it has been found that subsequent change of sensibility is negligible if the film is stabilized at a temperature of 90$^{\circ}$C for 2 hours, after polarization at 110$^{\circ}$C. This is achieved by simply passing the film through a heated chamber while allowing some slack within the chamber, so that the material may relax. Thus the polarizing temperature of 110$^{\circ}$C is so chosen to achieve a suitable margin above the operation and heat treatment temperatures.

Electrodes of conductive elastomer can now be applied by, for example, screen printing to give the patterns required before or subsequent to punching or cutting the required areas from the films, see below.

Certain variations to the process described above may be made. Thus two or more of the operation for stretching, polarizing, stabilization and electroding can be linked together without winding the films on to reels between stages. Further, the use of the polarization method wherein conductive elastomer sheets (the two belts in the drawing) are used as temporary electrodes is not limited to continuous polarization, but may also be applied as a batch process. Again, a sandwich of alternate layers of PVDF and conductive rubber may be made in an oven, and polarization may be effected by connecting alternate ones of the rubber layers via resistors to the terminals of an EHT supply and heating for the required time. The material is then allowed to cool before removing the polarizing field.

We now describe diaphragms using such foil and how they are used on electro-acoustic transducers.

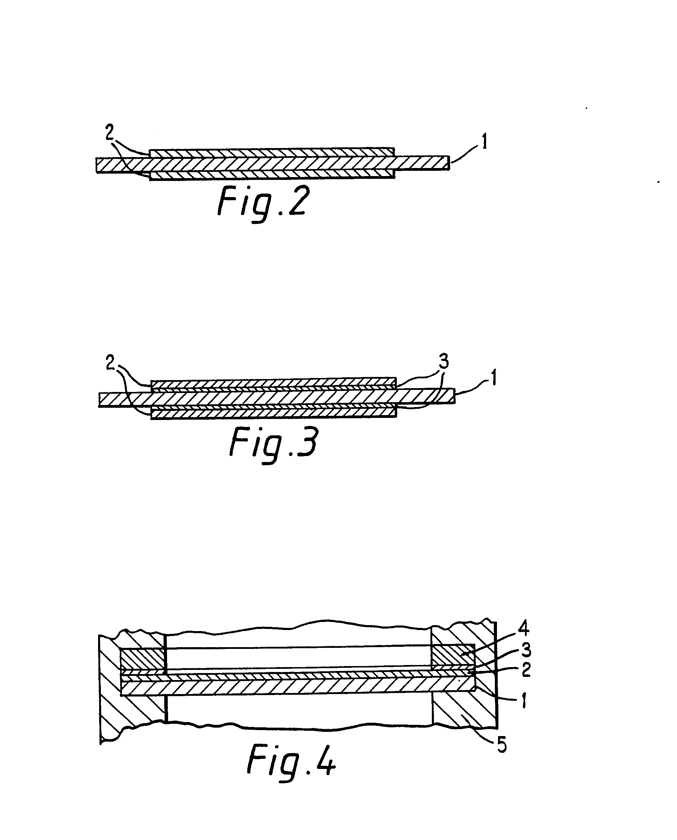

We refer first to Fig. 2. Here a transducer diaphragm 1 of plastics foil is shown, which is coated on each face with electrodes 2 of a conductive carbon-loaded elastomer. The diaphragm is assumed to be circular, being gripped at the rim, and having electrode connections (not shown) made to the electrodes 2. These electrodes may be applied by brushing, spraying or printing on of the elastomer-carbon mixture which has been dissolved in a suitable solvent. When the solvent evaporates a thin layer of carbon-loaded elastomer is left on the surface of the foil 1.

Note that the foil 1 may be piezoelectrically active material or an electret material.

It is sometimes convenient, e.g. when the diaphragm material has to be piezoelectrically active, to polarize the diaphragm using metal electrodes. In this case the elastomer may be applied over the metal electrodes to protect them and also to provide a reliable means of connection. An example of this is shown in Fig. 3 where metal electrodes 3 on the plastics foil 1 are coated with a carbon-loaded elastomer 2.

Fig. 4 shows how electrical contact may be made to an electrode 2 on a foil 1 by clamping it to a metal ring 4 by a frame 5. The ring 4 connected to one transducer terminal may be coated with precious metal or may itself have a coating of carbon-loaded polymer 3 on its contacting surface. Another possibility is to make the clamping material itself out of a conductive plastics material.

CLAIMS:

1. A process for the production of piezo-electric film, in which melt-extruded film of the material to be rendered piezo-electric is stretched, in a direction parallel to the extrusion direction with a stretch ratio and at a temperature such that the material of the film is converted into a form in which it can be rendered piezo-electric; characterized in this, that the stretched film is clamped between layers of conductive rubber or rubber-like material (5,6, Fig.1) to which is applied a polarizing voltage of a magnitude appropriate to the material to be rendered piezo-electric and to the thickness thereof, the film being held at that temperature for a time appropriate to the production of the desired piezo-electricity, whereafter the film is cooled to room temperature with the polarizing field still applied, that electrodes of an electrically-conductive elastomer are printed or otherwise formed onto the film in the required patterns, and electrodes being applied to one or both sides of the film and that the piezo-electric properties of the film are stabilized by heating the film at a temperature intermediate the temperature used in step (b) and the highest temperature to which it is expected that the film will be subjected when in use, the order in which steps (c) and (d) are performed being reversible.

2. A process as claimed in claim 1, characterized in this, that the film is PVDF the stretching being effected with a stretch ratio of the order of 4 to 1 and at a temperature of 100 to 140$^{\circ}$C to convert the sheet into the $\beta$ crystalline form; that the polarizing voltage is about 10$^8$ volts per metre in the case of a 12$\mu$m thick material, the film being held at a temperature of about 110$^{\circ}$C for 30 mins, whereafter the film is cooled to room temperature with the polarizing field still applied, and that piezo-electric properties are stabilized by heating the film at about 90°C for two hours.

3. A process as claimed in claim 1 or 2, characterized in this, that the polarization effected in step (b) is made continuous by passing the sheet material between two endless belts (5,6, Fig.1) having pads of electrically conductive material on their surfaces, which pads are separated by insulative regions.

4. A process as claimed in claim 1 or 2, characterized in this, that the polarization effected in step (c) is effected by setting up a sandwich of layers of conductive rubber with one or more layers of the film to be rendered piezo-electric, and connecting alternate ones of the conductive rubber layers of the two terminals of a supply source.

5. A process as claimed in claim 1, 2, 3 or 4, characterized in this, that said conductive rubber is a silicone rubber.

6. An electro-acoustic or electro-mechanical transducer, which includes a diaphragm of a film made by the process of any one of claims 1 to 5, characterized in this, that said electrically conductive electrodes on said one or both faces of the film each consist of said elastomer material with particles of an electrically conductive material, such as carbon, dispersed in it.

7. An electro-acoustic or electro-mechanical transducer which includes a diaphragm of an electrically active plastics material having electrically conductive electrodes on one or both of its two faces, characterized in this, that each said electrode is of an elastomer material having particles of an electrically conductive material, such as carbon, dispersed in it.

8.    A transducer, as claimed in claim 1, modified in that the diaphragm is an electret.

S.R.CAPSEY
CHARTERED PATENT AGENT
FOR THE APPLICANTS

0014043

Fig.1

*Fig.2*

*Fig.3*

*Fig.4*

**EUROPEAN SEARCH REPORT**

Application number

EP 80 30 0070

| DOCUMENTS CONSIDERED TO BE RELEVANT | | | CLASSIFICATION OF THE APPLICATION (Int. Cl. ) |
|---|---|---|---|
| Category | Citation of document with indication, where appropriate, of relevant passages | Relevant to claim | |
| | US - A - 3 449 094 (PHILLIP MORRIS INC.)<br><br>* Column 11, lines 65-75; column 12, lines 1-10; figure 2 *<br><br>-- | 1 | H 01 L 41/22<br>H 01 G 7/02 |
| | FR - A - 1 497 727 (PHILLIP MORRIS INC.)<br><br>* Page 9, column 2, last paragraph; page 10, column 1, paragraph 1; figure 2 *<br><br>-- | 1 | |
| | FR - A - 2 284 992 (KUREHA KAGAKU KOGYO KABUSHIKI KAISHA)<br><br>* Page 4, lines 3-24; figure 2 *<br>& GB - A - 1 507 326<br><br>-- | 1 | TECHNICAL FIELDS SEARCHED (Int.Cl. )<br><br>H 01 L 41/22<br>H 01 G 7/02 |
| | FR - A - 2 275 033 (M.M.M.)<br>* Claim 1; figure 1 *<br>& GB - A - 1 501 921<br><br>---- | 1 | |
| | | | CATEGORY OF CITED DOCUMENTS<br><br>X: particularly relevant<br>A: technological background<br>O: non-written disclosure<br>P: intermediate document<br>T: theory or principle underlying the invention<br>E: conflicting application<br>D: document cited in the application<br>L: citation for other reasons<br><br>&: member of the same patent family, corresponding document |
| The present search report has been drawn up for all claims | | | |

| Place of search | Date of completion of the search | Examiner |
|---|---|---|
| The Hague | 24-04-1980 | PELSERS |

EPO Form 1503.1  06.78